# FASCICULE DE BREVET EUROPEEN

(11) **EP 0 573 421 B1**
(45) Date de publication et mention de la délivrance du brevet: **14.09.1994**
(21) Numéro de dépôt: 91910332.5
(22) Date de dépôt: 07.05.1991
(51) Int. Cl.: G01N 27/00, G01B 7/34, G01N 21/01

(54) **INSTALLATION POUR L'ETUDE OU LA TRANSFORMATION DE LA SURFACE D'ECHANTILLONS PLACES DANS LE VIDE OU DANS UNE ATMOSPHERE CONTROLEE**
VORRICHTUNG ZUR ÜBERSUCHUNG ODER VERÄNDERUNG DER OBERFLÄCHE VON PROBEN IN EINER VAKUUMKAMMER ODER IN EINER KONTROLLIERTEN ATMOSPHÄRE
INSTALLATION FOR THE STUDY OR TRANSFORMATION OF SAMPLE SURFACES IN A VACUUM OR CONTROLLED ATMOSPHERE

(30) Priorité: 10.05.1990 FR 9005823
(43) Date de publication de la demande: 15.12.1993
(73) Titulaire: SIM (SOCIETE D'INVESTISSEMENT DANS LA MICROSCOPIE) SA, F-89000 Auxerre (FR)
(72) Inventeur: GOUDONNET, Jean-Pierre, F-21000 Dijon (FR); LACROUTE, Yvon, F-21850 Saint-Apollinaire (FR)
(74) Mandataire: Serin, Jean-Pierre
(86) Numéro de dépôt international: FR9100378
(87) Numéro de publication internationale: WO9117429

(56) Documents cités:
- US-A- 908 519
- REVIEW OF SCIENTIFIC INSTRUMENTS, vol. 61, no. 1, January 1990, New York, US, pp. 81-85 ; K. SUGIHARA et al. : "An ultrahigh vacuum tip transfer system for the scanning tunneling microscopy/field ion microscopy"
- REVIEW OF SCIENTIFIC INSTRUMENTS, vol. 60, no. 10, October 1989, New York, US, pp. 3113-3118 ; G.E. POIRIER et al. : "A new ultra-high vacuum scanning tunneling microscope design for surface science studies"

## Description

La présente invention concerne une installation pour l'étude de la surface d'échantillons placés dans le vide ou dans une atmosphère contrôlée. Elle s'applique notamment à la microscopie et/ou la spectroscopie à effet tunnel électronique, notamment dans l'ultravide, à la microscopie et/ou la spectroscopie à effet tunnel optique, ou encore à la gravure de structures nanométriques par des procédés microlithographiques optiques et/ou électroniques.

Il est bien connu que certains procédés de microscopie, de spectroscopie ou de microlithographie ne peuvent être conduits que dans une atmosphère particulièrement propre et contrôlée dans le but notamment de ne pas polluer la surface des échantillons que l'on étudie, ou bien des échantillons sur lesquels doivent être réalisées des structures de très petite taille (ce qui est le cas, par exemple, des circuits intégrés électroniques ou optiques). A cet égard, le vide est un milieu contrôlé particulièrement utile, et certaines applications nécessitent même de placer les échantillons et les moyens de mesure ou de gravure dans l'ultravide, c'est-à-dire dans un vide poussé. Dans ce sens, il a été développé un ensemble de techniques de microscopie connues notamment du document US-A-4 908 519 ou de spectroscopie mettant en oeuvre un balayage latéral de la surface d'un échantillon par une pointe conductrice de l'électricité ou de la lumière, cette pointe étant constitutive d'une microsonde recueillant, par un effet dit tunnel, des électrons ou des photons en nombre fortement dépendant d'une fonction exponentielle de la distance séparant ladite pointe de ladite surface ; il est courant d'appeler microscopie tunnel électronique, ou STM (Scanning Tunneling Microscopy), la technique faisant appel à des électrons, et microscopie tunnel optique, ou PSTM (Photon Scanning Tunneling Microscopy), la technique faisant appel à des photons. En règle générale, on appelera par la suite SXM l'ensemble de ces deux techniques et des techniques équivalentes, c'est-à-dire celles dans lesquelles une microsonde doit être positionnée à proximité immédiate de la surface d'un échantillon à étudier, que se soit dans l'air ou dans le vide. On désignera également par ces mêmes sigles les microscopes ou les moyens d'étude mettant en oeuvre ces techniques. On notera enfin que les SXM fonctionnent finalement tous à la façon d'un rugosimètre, et qu'on emploiera ce terme à titre général sans distinguer le principe physique mis en jeu pendant la mesure.

Dans tous les cas, les distances qu'il convient de maintenir entre ladite surface et la microsonde, ou pointe, sont très faibles, à savoir de 1 à 2 nanomètres pour le STM et de l'ordre du micromètre pour le PSTM. De telles valeurs imposent de minimiser au maximum les risques d'erreur de manipulation et nécessitent par conséquent d'utiliser des composants mécaniques, électroniques ou optiques très fiables ; dans le cas contraire, il peut arriver qu'il se produise des chocs plus ou moins destructeurs entre la microsonde et la surface de l'échantillon à étudier ou à graver, ces chocs étant provoqués par la perte du contrôle de la position spatiale de la pointe. Une autre cause d'endommagement provient d'un balayage trop rapide de la surface par rapport aux temps de réponse des composants ou des circuits électroniques et/ou mécaniques de contrôle de la distance entre la pointe et la surface ; la vitesse de balayage est une fonction évidente de la rugosité de la surface, c'est-à-dire qu'une surface lisse peut être balayée plus rapidement qu'une surface tourmentée, mais il n'est jamais aisé d'en avoir une idée avant l'étude. En cas de choc provoqué par une raison quelconque, la microsonde ou la pointe doit souvent être changée, ou au moins contrôlée, ce qui n'est pas toujours possible directement dans une enceinte où règne le vide, ou lorsqu'on se trouve dans une atmosphère contrôlée. Par ailleurs, le vieillissement des pointes, notamment des pointes métalliques dans le cas du STM, ou des pointes optiques dans le cas du PSTM, est un phénomène normal nécessitant leur remplacement ; par exemple, une pointe de STM peut devoir être remplacée en raison d'un réarrangement des atomes terminaux de la pointe, ou par capture d'un atome étranger, ou encore par un effet de dilatation thermique. Un dernier cas très important pour lequel il est essentiel de changer de microsonde ou de pointe pour l'étude de la surface d'un échantillon est celui où les mesures effectuées avec une première microsonde s'avèrent doûteuses, ou du moins suffisamment surprenantes pour devoir être confirmées par une seconde série de mesures ; en particulier, on sait pertinemment que le STM ne fournit une image topographique exploitable de la surface d'un échantillon que si la pointe métallique présente un profil théorique dont on connaisse parfaitement les effets sur la formation de l'image, c'est-à-dire vis à vis de l'intensité du courant tunnel s'établissant entre la surface et ladite pointe (l'exploitation d'une image "brute" consiste ainsi à déconvoluer l'image au sens mathématique du terme) ; cette condition n'étant pas toujours réalisée, il peut alors se révéler très utile d'établir des cartographies successives de la même surface au moyen de diverses pointes, l'idéal étant que ces pointes soient disponibles "in situ" pour ne pas risquer de contaminer la surface soumise à l'étude par une remise de l'échantillon en atmosphère normale non contrôlée, ou tout simplement pour des raisons de délai entre les balayages successifs - on sait en effet qu'une surface décapée sous vide se recouvre d'une couche d'oxydes ou d'oxygène au bout d'un délai d'environ 1 heure après son décapage, alors même que le vide est un ultravide, c'est-à-dire que cette surface se trouve dans une enceinte où règne une pression inférieure à 1,33 x 10⁻⁷ Pa (10⁻⁹ torr).

Or, on connaît peu d'installations adaptées à l'étude ou à la gravure de la surface d'échantillons placés dans le vide par des techniques du type SXM offrant la possibilité de changer rapidement la microsonde ou la pointe utilisée pour mener cette étude ou cette gravure sans avoir à "casser" le vide pour revenir à la pression atmosphérique, sans démonter l'enceinte pour accéder à la microsonde, ou sans interrompre l'étude de l'échantillon durant un temps excessif. A cet égard, seul un microscope à effet tunnel électronique développé par la société de droit britannique W.A.Technology Limited est muni d'un dispositif permettant de remplacer la pointe servant à la mesure sans avoir à ouvrir l'enceinte à ultravide ; les mécanismes mis en jeu à cet effet sont néanmoins complexes et ne permettent que le remplacement de la pointe. Or une avarie peut aussi atteindre le microscope lui-même, ou une partie du microscope, ce qui rend malgré tout nécessaire l'ouverture de l'enceinte à ultravide.

Par ailleurs, il est connu que l'introduction d'un échantillon dans une enceinte en atmosphère contrôlée, ou dans une enceinte à vide ou à ultravide n'est pas une chose aisée ; en particulier, il est essentiel de préserver au maximum l'étanchéité et la propreté des enceintes où se trouve la microsonde ou la pointe utile à la mesure ou à la gravure, ce qui demande une étude particulièrement soignée si on veut pouvoir introduire des échantillons dans l'enceinte d'étude ou de gravure sans risquer de "casser" le vide ou de contaminer l'atmosphère environnante. On connait de la publication Review of Scientific Instruments, Vol. 61, No. 1, January 1990, (New York, US), K. Sugihara et al.: "An ultrahigh vacuum tip tranfer system for the scanning tunneling microscopy/field in microscopy". Or ce problème n'est actuellement pas résolu sur les prototypes existant, ou bien il est résolu d'une manière très complexe, ce qui limite les applications industrielles des installations SXM, et notamment des microscopes à effet tunnel fonctionnant en atmosphère contrôlée ou dans l'ultravide.

La présente invention vise à remédier à tous ces inconvénients en proposant une installation pour l'étude ou la transformation de la surface d'échantillons (5) placés dans le vide ou dans une atmosphère contrôlée, comportant une enceinte principale (8) dans laquelle est placée une platine support (27) pour au moins un dispositif, dénommé SXM, dans lequel une microsonde, telle qu'une pointe conductrice de l'électricité ou de la lumière, est positionnée à proximité de la surface de l'échantillon (5) à étudier, que ce soit dans l'air ou dans le vide, ce dispositif étant destiné à la microscopie, à la spectroscopie ou à la gravure de la surface d'échantillons (5), par balayage de ladite surface par ladite microsonde, ladite platine support (27) étant pourvue de moyens pour la débrayer de l'enceinte principale (8) et de moyens pour la tourner sur elle-même autour d'un axe central, autorisant l'utilisation d'un ensemble de dispositifs SXM aménagés à la périphérie de ladite platine (27), installation caractérisée en ce que l'enceinte principale (8) est complétée par une enceinte de décapage (6) de la surface des échantillons (5) et par une enceinte d'introduction et de stockage (4) desdits échantillons (5), ceux-ci pouvant être manipulés au travers de l'installation (1) par l'extrémité d'une canne de transfert (15) pouvant être déplacée longitudinalement et en rotation axiale suivant l'axe d'alignement desdites enceintes (4, 6, 8).

Préférentiellement, la pointe est constitutive d'une microsonde recueillant, par un effet dit tunnel, des électrons ou des photons en nombre dépendant d'une fonction exponentielle de la distance séparant ladite pointe de la surface de l'échantillon.

Dans une forme d'exécution préférée de l'invention, la platine support peut, par exemple, être de forme générale circulaire, les dispositifs SXM périphériques étant placés dans des secteurs angulaires adjacents. Par ailleurs, il est clair que le nombre de tels dispositifs qu'il est possible d'installer sur la platine dépend directement de leur taille et du diamètre de la platine, et n'est normalement limité que par le poids de l'ensemble et son encombrement dans l'enceinte principale. A cet égard, il ne faut pas que le volume de l'enceinte principale soit trop important si on veut pouvoir y faire un vide poussé avec des moyens raisonnables, ou y maintenir une atmosphère contrôlée (enceinte propre de classe 1 par exemple).

La rotation de la platine remédie parfaitement à tous les inconvénients déjà mentionnés des installations actuelles, simplement du fait qu'elle permet de remplacer facilement :
- soit une pointe ou une microsonde servant à l'analyse ou à la gravure par une autre pointe ou une autre microsonde,
- soit au moins une partie d'un dispositif SXM par un autre situé sur la même platine, cet autre dispositif se trouvant dès l'origine dans l'enceinte principale.

On couvre de cette façon l'ensemble des interventions nécessaires en cas d'avaries affectant de tels dispositifs, ou utiles à la vérification des mesures obtenues sur un échantillon, ces interventions consistant en une simple permutation entre plusieurs dispositifs SXM ou entre plusieurs microsondes (telles que des pointes conductrices de la lumière ou de l'électricité), permutation obtenue directement par le débrayage et la rotation de la platine support.

Suivant une caractéristique complémentaire et importante de la présente invention, une enceinte de décapage de la surface des échantillons et une enceinte d'introduction et de stockage desdits échantillons complète l'enceinte principale ; après introduction des échantillons dans l'enceinte d'introduction et de stockage, ceux-ci sont prélevés par l'extrémité d'une canne de transfert pour être transférés vers l'enceinte de décapage où la surface à étudier ou à graver est éventuellement décapée puis, après ouverture d'une vanne séparant ladite enceinte de décapage de l'enceinte principale, vers un système support manipulable en rotation et en translation verticale et/ou latérale par l'intermédiaire d'un moyen manipulateur adéquat ; une fois l'échantillon en place sur son système support, le moyen manipulateur coopére avec un des dispositifs SXM périphériques de la platine placée dans l'enceinte principale de sorte à déposer l'échantillon au dessus de la pointe ou de la microsonde équipant ledit dispositif.

L'enceinte d'introduction et de stockage des échantillons et l'enceinte de décapage jouent ainsi le rôle d'un sas pouvant être remis à la pression atmosphérique pour l'introduction des échantillons, puis remis sous vide à une pression permettant l'ouverture de la vanne séparant lesdites enceintes de l'enceinte principale où règne un premier vide, ou dans laquelle l'atmosphère est contrôlée. Conformément à l'invention, la durée d'ouverture de la vanne correspond juste à celle qui est nécessaire à la récupération ou à la mise en place d'un échantillon sur le système support manipulable situé dans l'enceinte principale ; lors d'une récupération d'échantillon, la canne de transfert dépose celui-ci dans l'enceinte de stockage sur un système support adéquat, ce qui peut prendre un certain temps, mais il est clair que la vanne peut être refermée dès le retrait de la canne de transfert en deçà de ladite vanne ; dans le fonctionnement inverse, la canne de transfert prend un échantillon dans l'enceinte de stockage, et, suite à l'ouverture de la vanne, le transfère sur le système support manipulable situé dans l'enceinte principale. La coopération de la canne de transfert selon un mouvement principalement axial et du système support manipulable que l'on peut mouvoir en rotation et en translation verticale et/ou latérale rend ainsi possible l'étude ou la gravure successive d'échantillons variés disposés en attente dans l'enceinte de stockage, le dispositif SXM se trouvant quant à lui parfaitement à l'abri, dans l'enceinte principale, d'une remise à la pression atmosphérique ou d'une contamination extérieure.

D'autres caractéristiques et avantages de la présente invention ressortiront mieux de la description qui va suivre d'une forme d'exécution d'une installation principalement destinée à la microscopie à effet tunnel électronique, ou STM, dans l'ultravide en référence aux dessins annexés sur lesquels :
- la figure 1 représente une vue de face d'une installation conforme à l'invention,
- la figure 2 représente une vue de dessus de l'installation représentée sur la figure 1,
- la figure 3a représente une vue partiellement éclatée de l'enceinte d'introduction et de stockage des échantillons, montrant notamment le dispositif de stockage des échantillons ainsi que l'extrémité de la canne de transfert sur laquelle est vissé le cadre support d'un échantillon,
- la figure 3b est une vue rapprochée du dispositif de stockage des échantillons représenté sur la figure 3a,
- la figure 3c est une vue en perspective éclatée montrant l'assemblage du cadre support d'un échantillon,
- la figure 4a représente une vue partiellement éclatée de l'enceinte principale, montrant notamment le système support manipulable des échantillons, monté sur un bras manipulateur et coopérant avec l'extrémité de la canne de transfert portant le cadre support d'un échantillon,
- la figure 4b est une vue en perspective montrant le bras manipulateur ainsi que le système support des échantillons,
- la figure 4c est une vue par le dessous du système support représenté sur la figure 4b, dont on a retiré le plan inférieur de manière à montrer notamment la platine support d'un échantillon,
- la figure 5 représente une vue en perspective d'une platine support circulaire sur laquelle sont montés six microscopes à effet tunnel électronique, tandis qu'un bras manipulateur est en train de déposer le système support manipulable des échantillons sur l'un desdits microscopes, ladite platine support étant munie de son dispositif anti-vibratoire et suspendue dans l'enceinte principale par un double système périphérique à ressorts,
- la figure 6 est une vue en perspective éclatée montrant l'assemblage du dispositif anti-vibratoire de la platine support représentée sur la figure 5,
- la figure 7 est une vue en perspective montrant le détail des moyens de stabilisation du double système de suspension de la platine support et de son dispositif anti-vibratoire,
- la figure 8a est une vue partiellement éclatée de l'enceinte principale, montrant notamment le dispositif autorisant le débrayage et la rotation de la platine support de l'échantillon par l'extérieur de ladite enceinte,
- la figure 8b est une vue partielle éclatée du dispositif anti-vibratoire de la platine support montrant les connexions électriques nécessaires au fonctionnement des microscopes à effet tunnel électronique placés sur ladite platine,
- la figure 9 est une vue de côté d'un dispositif d'escamotage de l'embase portant la platine support, cette embase pouvant être abaissée et remontée à l'avant de l'enceinte principale pour l'entretien des éléments normalement placés dans ladite enceinte.

On rappelle tout d'abord le principe de la microscopie STM. La microscopie à effet tunnel électronique consiste à placer une pointe métallique extrêmement fine à proximité d'une surface conductrice, polarisée par rapport à ladite pointe. Si la distance entre la pointe et la surface est suffisamment petite, des électrons peuvent franchir, par effet tunnel, la barrière de potentiel due à la polarisation et il peut alors s'établir un courant d'électrons tunnel dont l'intensité varie suivant une loi exponentielle en fonction de la distance. Grâce à un système d'asservissement électronique, cette distance est ajustée de manière à maintenir un courant tunnel d'intensité constante, fixée comme référence dans la boucle de contrôle de l'asservissement. Un dispositif de balayage de la surface, perpendiculairement à la direction d'asservissement de la distance entre la pointe et ladite surface, permet de relever sa topographie par enregistrement des variations de la position de la pointe. Dans une autre variante de ce type de microscopie, la pointe est maintenue à une distance constante et on enregistre alors la variation d'intensité du courant tunnel pour en extraire directement la topographie de la surface. La forte dépendance de l'intensité du courant tunnel en fonction de la distance, l'utilisation d'un asservissement électronique à large bande passante et l'utilisation de céramiques piezoélectriques pour les déplacements verticaux et horizontaux respectifs de la pointe et de la surface à analyser, permettent d'obtenir des images topographiques avec une résolution égale à des fractions d'angstroems (typiquement 0,05 A) perpendiculairement à cette surface et à 0,1 angstroems parallèlement à celle-ci. Cette résolution est d'autant meilleure que l'analyse de la surface, normalement très polluée dans l'air, s'effectue dans une atmosphère contrôlée et on obtient de fait les meilleures images lorsque la pointe et la surface sont placées dans une enceinte où règne un vide poussé.

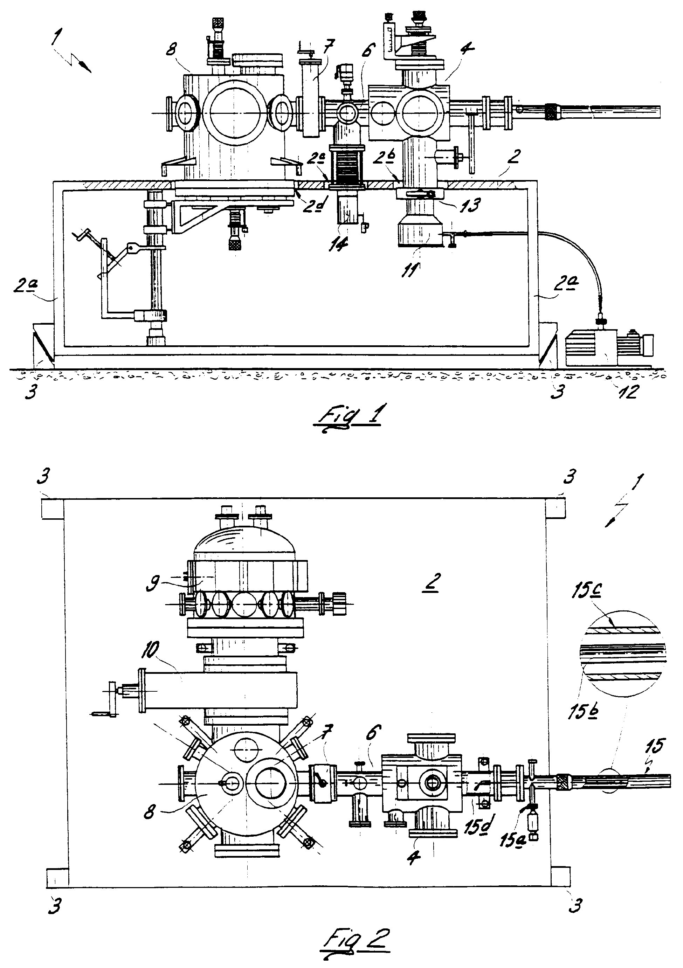

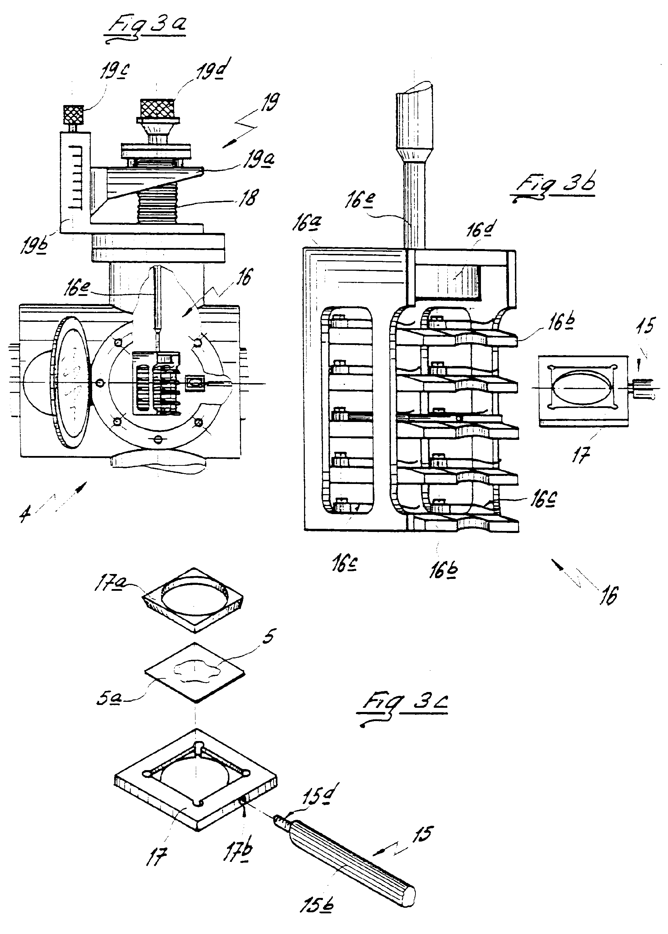

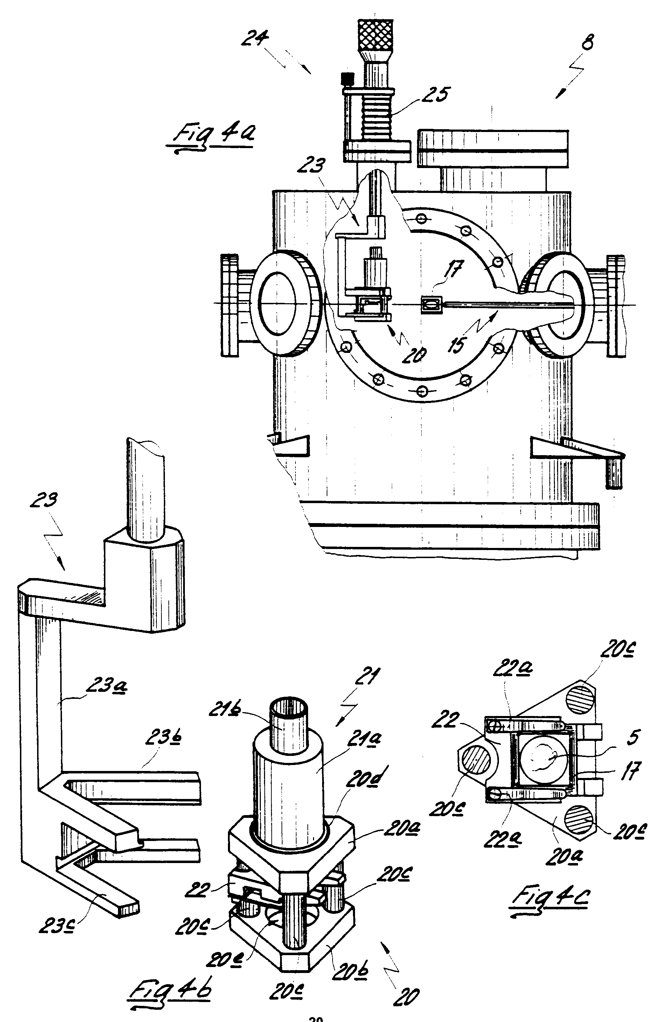

Suivant la présente invention, et conformément aux figures 1 et 2 annexées, une installation 1 pour la microscopie tunnel électronique dans l'ultravide comporte tout d'abord une table horizontale 2 munie de montants verticaux 2a s'appuyant sur le sol par l'intermédiaire de quatre supports pneumatiques anti-vibratoires 3 pour isoler la table 2 des vibrations du bâtiment où se trouve l'installation 1. La hauteur des montants verticaux 2a permet d'accéder facilement sous la table 2 et d'y installer les éléments nécessaires au fonctionnement de l'installation 1. Par ailleurs, selon la présente invention, l'installation 1 est principalement constituée d'une enceinte d'introduction et de stockage 4 des échantillons 5 (fig.3c) à analyser, dans le prolongement de laquelle se trouve une enceinte de décapage ionique 6 desdits échantillons 5, puis une vanne 7, par exemple du type d'une vanne tiroir s'ouvrant par exemple verticalement vers le haut, et enfin une enceinte principale 8 dans laquelle on effectue la microscopie des échantillons 5.

Dans l'enceinte principale 8 règne un vide poussé, ou ultravide, c'est-à-dire une pression de l'ordre de 10⁻¹⁰ torr, favorable à l'obtention d'images topographiques de la surface des échantillons 5 par microscopie tunnel électronique. Cette pression est obtenue, d'une manière conventionnelle, grâce à une pompe ionique 9 (fig.2) reliée sur le côté de l'enceinte principale 8 ; celle-ci peut néanmoins être isolée de la pompe ionique 9 par l'intermédiaire d'une seconde vanne 10 (fig.2), du type d'une vanne tiroir s'ouvrant par exemple horizontalement.

Dans l'enceinte d'introduction et de stockage 4 et dans l'enceinte de décapage ionique 6 des échantillons 5 règne un vide moins poussé que celui règnant dans l'enceinte principale 8 sans, toutefois, être un vide primaire ; à cet égard, l'enceinte d'introduction et de stockage 4 est reliée à sa partie inférieure à une pompe turbomoléculaire 11 (fig.1), suffisante pour établir une pression d'environ 10⁻⁶ dans les deux enceintes (4, 6). Cette pompe 11 est mise en série avec une pompe à palettes 12 chargée d'établir un vide primaire dans les enceintes (4, 6, 8) avant le déclenchement desdites pompes 9 et 11. Une vanne horizontale 13, également du type d'une vanne tiroir, sépare la base de l'enceinte d'introduction et de stockage 4 de la pompe turbomoléculaire 11.

En situation de travail, c'est-à-dire lorsque les différents vides ont été établis dans les enceintes (4, 6, 8), les vannes (7, 10, 13) sont normalement fermées afin de ne pas perturber les mesures effectuées sur l'échantillon 5 en cours d'analyse. En outre, la pompe ionique 9 et la pompe turbomoléculaire 11 ont l'avantage de pouvoir être stoppées facilement dès que les vannes 7 et 13 sont fermées. A ce titre, il est évident que l'on pourrait remplacer la pompe ionique 9 par une pompe de performance équivalente du type d'une pompe turbomoléculaire ou d'une pompe cryogénique ; on pourrait également, le cas échéant, équiper l'enceinte principale 8 de plusieurs pompes 9 pour tenir compte du volume intérieur de ladite enceinte 8, ce qui permettrait, ainsi qu'on le décrira par la suite, d'augmenter l'autonomie de l'installation 1. Ces modifications normalement à la portée de l'homme de métier rentrent ainsi pleinement dans le cadre de la présente invention.

Comme on peut le voir sur la figure 1, les enceintes (4, 6, 8) reposent sur la table horizontale 2 et partagent un même plan moyen horizontal situé légèrement au dessus de ladite table 2. Des passages 2b, 2c et 2d sont également ménagés dans la table 2, soit pour le passage de certaines parties des enceintes (4, 6, 8), soit pour leur dégagement par le bas. A cet égard, un canon ionique 14 (fig.1) équipe la partie inférieure de l'enceinte de décapage ionique 6, et délivre si nécessaire un courant d'ions en direction de la surface d'un échantillon 5 à analyser ; ce décapage des échantillons 5, au passage dans ladite enceinte 6, n'est pas obligatoire car il s'agit d'une méthode destructrice modifiant la surface des matériaux traités, même si on sait, par ailleurs, qu'un tel décapage n'atteint que les premières couches atomiques de ladite surface.

L'installation 1 comprend également, selon une caractéristique particulièrement avantageuse de l'invention, une canne de transfert 15 (fig.2) située dans le plan moyen horizontal des enceintes (4, 6, 8) et pouvant être déplacée longitudinalement et en rotation axiale suivant l'axe d'alignement desdites enceintes (4, 6, 8) pour assurer les transferts réciproques d'un échantillon 5 entre l'enceinte d'introduction et de stockage 4 et l'enceinte principale 8, après ouverture de la vanne 7. Les manoeuvres longitudinales de la canne de transfert 15 sont obtenues par l'intermédiaire d'un dispositif 15a à crémaillère et pignon, tandis que ladite canne 15 est par ailleurs constituée d'un arbre 15b tourillonné dans un manchon coaxial 15c lui procurant sa rotation axiale.

Conformément à la figure 3c, les échantillons 5 sont montés sur un cadre support 17 dans lequel ils sont maintenus par un contre-cadre 17a, tandis qu'un trou taraudé 17b est prévu sur le côté dudit cadre 17 de sorte qu'il soit possible d'y visser l'extrémité 15d de l'arbre 15b de la canne de transfert 15. En règle générale, les échantillons 5 sont conducteurs de l'électricité et sont disponibles aux dimensions du contre-cadre 17a, ce qui permet de les maintenir sans problème sur le cadre 17. Dans le cas d'échantillons 5 biologiques, on dispose de plaquettes 5a en graphite conducteur sur lesquelles il est facile de faire adhérer par capillarité un échantillon biologique 5 noyé dans un solvant ; les dimensions des plaquettes 5a que l'on peut utiliser sont bien entendu en rapport avec les dimensions du cadre 17 et du contre-cadre 17a.

Conformément à la figure 3a, qui représente une vue partiellement éclatée de l'enceinte d'introduction et de stockage 4 des échantillons 5, l'extrémité 15d de l'arbre 15b de la canne de transfert 15 (fig.3c) vient coopérer avec un dispositif de stockage 16 des échantillons 5 à analyser. Suivant une variante préférée de la présente invention, décrite en référence à la figure 3b le dispositif 16 se présente sous la forme d'une étagère 16a compartimentée pour recevoir les cadres support 17 des échantillons 5 ; à cet effet, les cadres support 17 sont introduits sur des claies horizontales 16b de l'étagère 16a, où ils sont maintenus d'une manière sûre par un jeu de deux lames ressorts 16c. Par ailleurs, un élément chauffant 16d est prévu au dessus de la claie horizontale 16b la plus haute et permet, éventuellement, de dégazer un échantillon 5 préalablement placé avec son cadre support 17 sur ladite claie 16b.

Conformément à la figure 3a, l'étagère 16a est soutenue à sa partie supérieure, au dessus de l'élément chauffant 16d, par une tige verticale 16e traversant la paroi supérieure de l'enceinte 4 au niveau d'un joint métallique flexible 18 du type à soufflets, ladite tige 16e étant maintenue à son sommet par un "dispositif conventionnel de rotation à translation coaxiale" 19 servant à la translation verticale et au pivotement vertical du dispositif de stockage 16. Lors de la manipulation verticale de l'étagère 16a, le joint métallique flexible 18 du type à soufflets s'écrase ou s'allonge sous l'effet du déplacement d'une coulisse horizontale 19a le long d'un axe vertical 19b éventuellement gradué pour un repèrage aisé de la hauteur de ladite étagère 16a ; une vis micrométrique 19c, solidaire du sommet de l'axe vertical 19b, permet de déplacer verticalement la coulisse 19a ; ce déplacement résulte de la transformation du mouvement de rotation de la vis 19c en un mouvement de translation de la coulisse 19a par l'intermédiaire d'un classique moyen à vis sans fin non représenté sur les figures, ou par tout autre moyen équivalent. Par ailleurs, un vernier 19d est fixé au sommet de la tige 16e de l'étagère 16a de telle sorte qu'on puisse contrôler la rotation du dispositif de stockage 16.

Pour récupérer un échantillon 5 reposant avec son cadre support 17 sur une claie horizontale 16b, on amène ladite claie 16b au niveau du plan moyen des enceintes (4, 6, 8) dans lequel se trouve également l'extrémité 15d de l'arbre 15b de la canne de transfert 15. Eventuellement, le vernier 19d permet de tourner l'étagère 16a sur elle-même pour amener le trou taraudé 17b du cadre support 17 au droit de ladite extrémité 15d de telle sorte qu'on puisse visser la canne de transfert 15 sur ledit cadre 17 après l'avoir elle-même avancée au moyen du dispositif 15a à crémaillère et pignon (fig.2) ; le retrait de la canne de transfert 15 entraîne alors le dégagement du cadre support 17, supportant l'échantillon 5, de l'intervalle compris entre deux lames ressorts 16c prévu sur la partie supérieure de la claie horizontale 16b. On remonte ensuite l'étagère 16a au dessus du plan moyen des enceintes (4, 6, 8), dégageant par la-même le trajet longitudinal de la canne de transfert 15. L'échantillon 5 peut alors être transféré vers l'enceinte de décapage ionique 6, ou vers l'enceinte principale 8 après ouverture de la vanne tiroir 7. Eventuellement, l'arbre 15b de la canne de transfert 15 peut être tourné sur lui-même, ce qui permet éventuellement de choisir la face de l'échantillon 5 que l'on désire analyser par microscopie STM ; de cette façon, il est également possible de stocker les échantillons 5 dans le dispositif de stockage 16 avec leur face à étudier placée sur le dessus, alors même que, suivant la forme d'exécution préférée de l'installation 1 telle que représentée sur la figure 1, le canon ionique 14 délivre un courant d'ions, par exemple d'ions argon, sur la face inférieure de l'échantillon 5 qui lui est présenté. On verra par la suite que cette disposition de l'installation 1 procure certains avantages quant à l'ergonomie des 5 dispositifs STM placés dans l'enceinte principale 8.

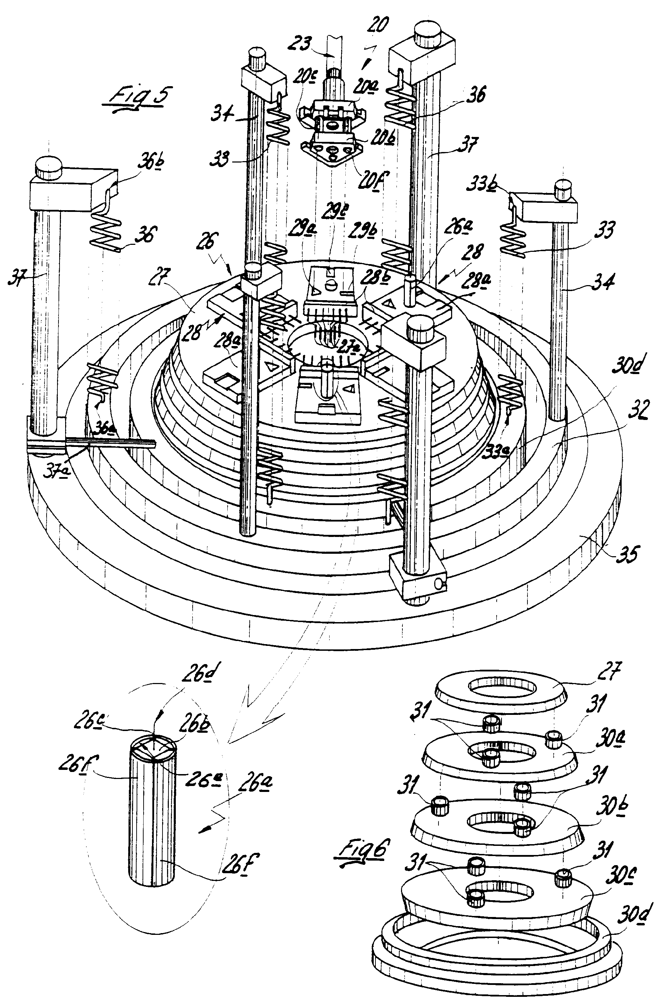

Après son transfert dans l'enceinte principale 8, un échantillon 5 est récupéré par un système support 20 d'une manière décrite en référence aux figures 4a, 4b et 4c. Suivant les figure 4a et 4b, le système support 20 est équipé d'un moyen de déplacement vertical, du type d'un moteur à piezoélectrique 21, susceptible de déplacer verticalement une micro-platine 22 sensiblement horizontale, adaptée pour recevoir le cadre support 17 de l'échantillon 5. Le système support 20 est lui-même i supporté par un bras manipulateur 23 qui est assujetti à un dispositif conventionnel de rotation à translation coaxiale 24 traversant la paroi supérieure de l'enceinte principale 8 au niveau d'un joint métallique flexible 25 du type à soufflets.

Suivant les figures 4b et 4c, le système support 20 présente deux plans 20a et 20b superposés, préférentiellement de forme triangulaire, réunis par trois colonnes verticales 20c placées chacune entre un sommet du plan triangulaire supérieur 20a et un sommet du plan triangulaire inférieur 20b. Ces deux plans 20a et 20b présentent respectivement un alésage circulaire 20d et un alésage circulaire 20e, le trou circulaire supérieur 20d étant aménagé pour recevoir le moteur à piezoélectrique 21. Le moteur à piezoélectrique 21 comporte, pour sa part, un cylindre extérieur 21a à l'intérieur duquel peut être déplacé un cylindre intérieur 21b soutenant par sa base la micro-platine 22, cette dernière maintenant le cadre support 17 d'un échantillon 5 par encastrement dans un jeu de lames ressorts 22a. On notera que le moteur 21 présente une course verticale d'excursion pouvant atteindre 10 millimètres avec une résolution égale à 1 nanomètre, ce qui permet de déplacer verticalement l'échantillon 5 d'une manière très fine.

Par ailleurs, selon la figure 4b, le bras manipulateur 23 présente une forme correspondant à la préhension du système support 20, c'est-à-dire qu'il possède une tige verticale 23a supportant à sa partie inférieure deux appuis 23b et 23c superposés, s'évasant en forme de "V" ouverts à l'opposé de ladite tige 23a pour venir chacun épouser deux arêtes adjacentes des plans triangulaires supérieur 20a et inférieur 20b dudit système support 20.

Après encastrement du cadre support 17 d'un échantillon 5 entre le jeu de lames ressorts 22a de la micro-platine 22 équipant le système support 20, on dévisse l'extrémité 15d de l'arbre 15b de la canne de transfert 15, que l'on retire en deçà de la vanne tiroir 7 qui est ensuite refermée. L'échantillon 5 se trouve ainsi "suspendu", dans le système support 20, au bout du bras manipulateur 23 (fig.4a). Après fermeture de la vanne 7, la pression dans l'enceinte principale 8, qui a remonté au niveau de la pression des enceintes de stockage 4 et de décapage 6 à cause de la mise en correspondance des deux parties de l'installation 1, retrouve progressivement son niveau d'origine grâce à l'action de la pompe à vide 9 qui lui est rattachée.

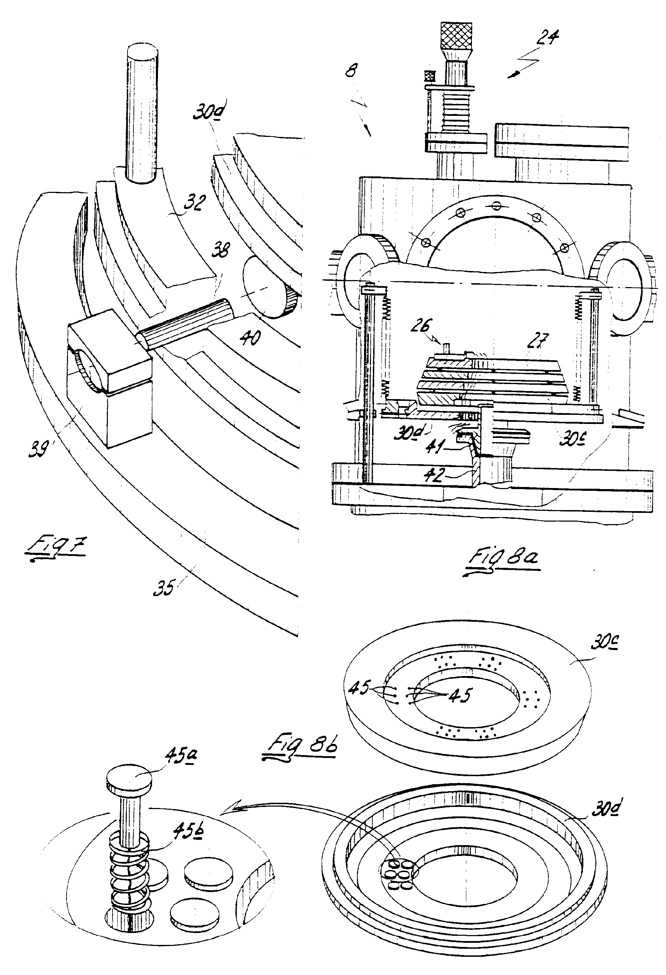

En agissant sur le dispositif de rotation à translation coaxiale 24, on va alors déposer le système support 20 au dessus d'un dispositif 26 destiné à la microscopie STM et reposant, dans l'enceinte principale 8, sur une platine support 27 qu'on décrira maintenant en référence à la figure 5. Conformément à cette figure, la platine support 27 est de forme circulaire et comporte six dispositifs 26 périphériques placés dans six secteurs angulaires adjacents d'ouverture égale à 60°. Ce nombre n'est pas limitatif mais résulte du choix d'un encombrement maximum de ladite platine 27 dans l'enceinte principale 8. Il est bien entendu que l'on pourrait placer plus ou moins de six dispositifs 26 à la périphérie de la platine support 27, dans autant de secteurs angulaires adjacents qu'il y aurait de tels dispositifs 26.

Il est tout d'abord décrit, en référence à la figure 5, la constitution d'un dispositif STM 26. Celui-ci comporte un tube piezoélectrique 26a cylindrique au sommet duquel est placée une pièce carrée 26b, collée par ses quatre coins, et traversée en son centre par un petit tube vertical 26c, du type d'une aiguille hypodermique tronquée ; à l'intérieur de ce petit tube 26c se trouve un fil en platine irridié, en tungstène ou en molybdène à l'extrémité duquel est préalablement réalisé une pointe 26d servant de microsonde pour la microscopie STM. Le diamètre de ce fil est légèrement plus petit que le diamètre intérieur du petit tube vertical 26c, de telle sorte que ledit fil puisse être préformé pour tenir par élasticité à l'intérieur dudit tube 26c (typiquement, le diamètre du fil vaut 0.250 mm pour un diamètre intérieur du petit tube 26c de 0.33 mm). Par ailleurs, le tube piezoélectrique 26a est un tube céramique, fabriqué dans un matériau du type PZT (5H) à faible dilatation thermique ; il présente une électrode 26e continue recouvrant sa surface intérieure, ainsi qu'une électrode extérieure fendue longitudinalement en quatre petites électrodes 26f, de sorte que, par application d'une tension entre l'électrode intérieure 26e et les électrodes extérieures 26f, on puisse allonger le tube piezoélectrique 26a, provoquant le déplacement vertical de la pointe 26c, tandis que, par application d'une tension entre deux électrodes 26f opposées, le tube piezoélectrique 26a se plie perpendiculairement à son axe, provoquant le déplacement latéral de ladite pointe 26d. On notera que, dans ces conditions, on sait que les résolutions verticale et latérale des déplacements de la pointe 26d sont respectivement égales à 0,05 angstroem et à 0,1 angstroem.

Par ailleurs, chaque tube piezoélectrique 26a est normalement posé verticalement sur une embase 28 qui est fixée sur la platine 27. Cette embase 28 comporte une partie carrée 28a, au centre de laquelle est posé le tube piezoélectrique 26a, et un rebord 28b s'étendant sur le côté le plus interne de ladite partie carrée 28a. Six connecteurs électriques horizontaux traversent de part en part le rebord 28b pour amener six fils vers le centre de la platine support 27 ; cinq de ces six fils servent au contrôle des cinq électrodes 26e et 26f du tube piezoélectrique 26a, le sixième fil étant relié au fil en platine, en tungstène ou en molybdène à l'extrémité duquel est réalisée la pointe 26d du dispositif 26. Les contacts électriques entre fils et connecteurs électriques sont réalisés au moyen d'une colle conductrice chargée à l'argent. L'embase 28 est quant à elle réalisée dans un matériau vitrocéramique usinable ne dégazant pas sous vide, tel que par exemple celui connu sous le nom de "Macor". Au centre de la platine 27, il est prévu des connecteurs verticaux 27a reliés aux connecteurs électriques horizontaux permettant de faire passer les fils d'alimentation et de mesure des tubes piezoélectriques 26a par le centre de ladite platine 27.

En outre, un trou 29a en forme de trièdre, une rainure 29b en forme de dièdre et un plan 29c sont usinés sur la partie carrée 28a de l'embase 28, de manière à former une emboîture dite "trou/trait/plan" avec trois plots sphériques 20f situés sous le plan triangulaire inférieur 20b du système support 20 de l'échantillon 5, juste à l'amplomb de chacune des trois colonnes verticales 20c ; l'emboîture "trou/trait/plan" réalise une liaison complète à zéro degré de liberté procurant une grande précision dans le positionnement du système support 20 sur l'embase 28. De cette façon, on comprend bien que le tube piezoélectrique 26a est engagé dans l'alésage circulaire 20e (fig.4b) prévu à cet effet dans le plan triangulaire inférieur 20b du système support 20, la hauteur des colonnes verticales 20c étant choisie de manière à amener l'échantillon 5 à proximité de la pointe 26d du dispositif STM 26. Ainsi réunis sur la platine 27, le tube piezoélectrique 26a et le système support 20, muni de son moteur 21 actionnant la micro-platine 22 portant un échantillon 5 dans son cadre support 17 (fig.4b), constituent un microscope STM complet de conception originale dont la structure est très avantageuse ; en effet, contrairement aux microscopes conventionnels, l'approche dite "grossière" n'est pas directement effectuée par un déplacement de la pointe 26d ou de son tube support 26a, mais par celui de l'échantillon 5, la microscopie elle-même étant réalisée par le seul déplacement très précis de la pointe 26d au moyen du tube piezoélectrique 26a. Cette séparation spatiale des fonctions d'approche et de déplacement fin réciproques entre la surface de l'échantillon 5 et la pointe 26d procure un contrôle très fiable du fonctionnement d'un microscope STM, contribuant à sa facilité de maintenance et à sa simplicité d'utilisation. En outre, même en disposant plusieurs dispositifs STM 26 sur la platine support 27, il est inutile d'équiper chacun de ces dispositifs 26 d'un moteur piezoélectrique 21 coûteux, lourd et encombrant ; de même, le système support 20 d'un échantillon 5 est réalisé en un unique exemplaire, amovible et manipulable, dont le remplacement éventuel ne nécessite pas une intervention toujours risquée sur les organes les plus précis et les plus fragiles d'un microscope STM, à savoir le dispositif 26 avec son tube piezoélectrique 26a portant la pointe 26d. Il est donc clair que cette disposition de l'installation 1 contribue d'une manière importante à sa fiabilité et à son entretien.

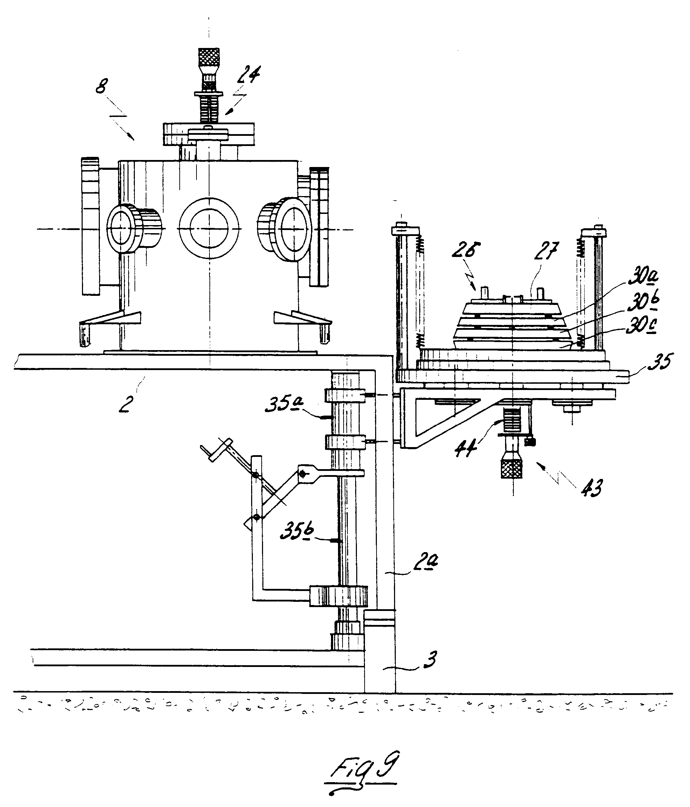

Il ressort également de ce qui précède que les précisions requises dans le Positionnement et les déplacements relatifs de la pointe 26d et de l'échantillon 5 placé sur son système support 20 nécessitent que la platine support 27 soit parfaitement isolée des vibrations extérieures. A cet égard, conformément à une caractéristique complémentaire de l'installation 1 décrite en référence à la figure 6, la platine 27 est montée sur un ensemble de trois couronnes 30a, 30b et 30c superposées les unes sur les autres suivant des plans successifs parallèles entre eux, distants les uns des autres de la hauteur de trois amortisseurs 31 identiques réalisés en une matière souple et élastique, par exemple un élastomère fluoré du type de celui connu sous le nom de "Viton" ; les amortisseurs 31 sont disposés angulairement à 1200 les uns des autres sur une couronne inférieure (30a, 30b, 30c) pour supporter la couronne qui lui est immédiatement supérieure (27, 30a, 30b respectivement), la couronne 30c la plus basse constituant une assise pour toutes les autres couronnes (27, 30a, 30b). Préférentiellement, les amortisseurs 31 sont des cylindres de révolution d'axes perpendiculaires à leur surface d'appui sur les couronnes (30a, 30b, 30c) et sont décalés d'un angle de 60° d'un étage à l'autre. L'empilement de plaques ainsi réalisé est connu pour isoler d'une manière satisfaisante les dispositifs STM 26 des vibrations pouvant affecter l'installation 1, mais s'avère insuffisante dans les environnements très perturbés.

C'est pourquoi, suivant une caractéristique complémentaire de l'invention, l'empilement de la platine support 27 et des couronnes (30a, 30b, 30c) présente une forme tronconique ; cette disposition favorise l'amortissement des vibrations par rapport à un empilement dans lequel toutes les couronnes auraient le même diamètre (empilement cylindrique).

Par ailleurs, suivant une autre caractéristique de la présente invention décrite en référence aux figures 5 et 6, on munit l'empilement précédemment décrit d'un double système de suspension lui procurant une isolation complémentaire ; à cet effet, l'assise constituée par la couronne 30c est encastrée dans une première couronne extérieure 30d qui est maintenue en suspension par rapport à une deuxième couronne extérieure 32 au moyen de trois ressorts identiques 33 disposés sur la périphérie de la couronne 30d à 120° les uns des autres ; chacun des trois ressorts 33 travaille en élongation entre un point d'attache inférieur 33a pris sur la première couronne extérieure 30d et un point d'attache supérieur 33b pris au sommet d'une colonne verticale 34, montée solidaire sur la deuxième couronne extérieure 32.

Cette dernière est elle-même maintenue en suspension par rapport à une embase 35 solidaire du bâti de l'enceinte principale 8 au moyen de trois ressorts 36 identiques, disposés sur la périphérie de ladite deuxième couronne extérieure 32, chacun de ces ressorts 36 travaillant en élongation entre un point d'attache inférieur 36a pris sur la deuxième couronne extérieure 32 et un point d'attache supérieur 36b pris au sommet d'une colonne verticale 37 montée solidaire de ladite embase 35. En outre, les ressorts 33 et 36 sont décalés de 60° les uns par rapport aux autres et les ressorts 33 ont un coefficient de raideur supérieur au coefficient de raideur des ressorts 36.

En position suspendue, la platine 27 est parfaitement isolée des vibrations extérieures transmises au travers du bâti de l'installation 1 et en partie déjà amorties par les quatre supports pneumatiques anti-vibratoires 3 (fig.1) aménagés à la base des montants verticaux 2a de la table 2. Dans cette position, représentée sur la figure 5, on s'arrange pour que la couronne extérieure 32 et l'embase 35 partagent sensiblement le même plan horizontal. En outre, conformément à la figure 7, il est possible d'accélérer la stabilisation des oscillations se produisant à la mise en suspension de la platine 27 en ménageant un jeu de six barreaux aimantés 38, traversant horizontalement la couronne extérieure 32 de part en part, disposés à 60° les uns des autres, et se trouvant par exemple en décalage de 30° par rapport aux ressorts 33 et 36 ; ces barreaux aimantés 38 coopèrent d'une part avec un premier jeu de six masses magnétiques 39 montées solidaires de l'embase 35 pour la stabilisation des oscillations de la deuxième couronne extérieure 32 par rapport à ladite embase 35, et d'autre part avec un second jeu de six masses magnétiques 40 montées solidaires en dessous de la première couronne extérieure 30d pour la stabilisation des oscillations de ladite couronne extérieure 30d par rapport à la deuxième couronne extérieure 32.

On notera également que les points d'attache supérieurs 33b des ressorts 33 sur les colonnes verticales 34 ainsi que les points d'attache supérieur 36b des ressorts 36 sur les colonnes verticales 37 peuvent être abaissés ou surélevés, ce qui permet de procéder à l'équilibrage de la platine 27 en tenant compte du dépôt du système support 20 d'un échantillon 5 sur l'embase 28 d'un des dispositifs STM 26 périphériques de ladite platine 27 (fig.5).

Suivant une caractéristique essentielle de la présente invention décrite en référence à la figure 8a et à la figure 9, la platine 27 peut être débrayée de l'enceinte principale 8 et tournée sur elle-même autour d'un axe central pour permettre l'utilisation de l'un quelconque des dispositifs 26 aménagés à sa périphérie sans qu'il soit pour autant nécessaire de "casser" le vide poussé établi dans l'enceinte principale 8.

A cet effet, la couronne d'assise 30c est fixée rigidement à une douille d'accouplement 41 traversant en son centre la première couronne extérieure 30d dans laquelle est encastrée ladite couronne d'assise 30c. Cette douille 41 s'étend verticalement vers le bas pour coopérer avec un manchon cylindrique creux 42 qui est assujetti à un dispositif conventionnel de rotation à translation coaxiale 43 (fig.9), traversant la paroi inférieure de l'enceinte principale 8 au niveau d'un joint métallique flexible 44 du type à soufflets. Lorsque le manchon 42 est remontée en position haute, il vient s'encastrer dans la douille 41 ce qui permet de soulever l'ensemble constitué de la platine support 27, des couronnes inférieures 30a, 30b, 30c et de la première couronne extérieure 30d, provoquant, du même coup, le relâchement progressif des ressorts 33 et 36 (fig.5). A une hauteur prédéterminée par trois tiges horizontales 37a (fig.5) maintenues par les colonnes verticales 37 pour servir de butée haute à la première couronne extérieure 30d, la couronne d'assise 30c se désencastre de ladite couronne extérieure 30d ; à ce moment là, il devient possible de tourner l'ensemble constitué de la platine support 27 et des couronnes inférieures 30a, 30b, 30c autour de l'axe vertical défini par la douille 41 et le manchon 42, la platine 27 étant ainsi libre en rotation pour le positionnement de l'un quelconque des dispositifs STM 26 dans la position d'utilisation choisie. On peut ensuite ramener la platine 27 en position basse suspendue. Toutes ces opérations se font de l'extérieur de l'enceinte principale 8 par le moyen du dispositif conventionnel de rotation à translation coaxiale 43, le vide résidant dans ladite enceinte 8 n'étant par conséquent jamais "cassé" lors des manipulations de la platine 27.

Par ailleurs, suivant la figure 8b, des connecteurs verticaux 45 sont prévus au centre de la couronne d'assise 30c pour relier les fils électriques issus des connecteurs verticaux 27a (fig.5), qui sont nécessaires au fonctionnement des tubes piezoélectriques 26a et à la mesure du courant tunnel de la pointe 26d. Ces connecteurs 45, propres à chacun des dispositifs STM 26, viennent normalement au contact de plots conducteurs 45a soutenus par des petits ressorts 45b, placés à cet effet dans des logements verticaux de la première couronne extérieure 30d au droit des connecteurs 45 ; les plots 45a sont reliés vers le bas à des fils électriques traversant l'enceinte principale 8 d'une manière conventionnelle. De cette façon, lorsque la couronne d'assise 30c se désencastre de la couronne extérieure 30d sous l'effet de la remontée du manchon 42, le contact entre les connecteurs 45 et les plots conducteurs 45a est rompu, ce qui permet de tourner librement la couronne d'assise 30c par rapport à la couronne extérieure 30d, sans être gêné par aucun fil électrique ; en position basse, les connecteurs 45 propres au dispositif STM 26 utilisé reviennent au contact desdits plots 45a en écrasant les petits ressorts 45b dans leur logement, ce qui assure une connexion électrique suffisante.

Suivant une autre caractéristique de l'installation 1 conforme à la figure 9, l'embase 35 soutenant l'ensemble constitué de la platine support 27, des couronnes inférieures 30a, 30b, 30c, de la première couronne extérieure 30d et de la seconde couronne extérieure 32 peut être escamotée par le dessous de l'enceinte principale 8. A cet effet, l'embase 35 est articulée à sa périphérie autour d'un axe vertical, présentant un fourreau 35a monté coulissant autour d'un arbre central vertical 35b, ledit fourreau 35a étant rigidement solidaire de ladite embase 35. De cette façon, on peut monter ou descendre l'embase 35 par rapport au niveau inférieur de fermeture de l'enceinte principale 8, puis dégager l'embase 35 de dessous ladite enceinte 8 afin de pouvoir intervenir sur l'ensemble précédemment mentionné (constitué de la platine support 27, des couronnes inférieures 30a, 30b, 30c, de la première couronne extérieure 30d et de la seconde couronne extérieure 32), préférentiellement à l'avant de l'installation 1. Cette disposition de l'installation 1 conforme à l'invention raccourcit notablement le temps des interventions qui sont parfois nécessaires à l'entretien des éléments normalement situés dans l'enceinte principale 8, interventions dont la fréquence est notablement diminuée du fait de l'ensemble des caractéristiques de ladite installation 1, qui ont été longuement développées dans la description précédente.

Il est à la portée de l'homme de métier d'adapter les solutions techniques retenues pour le cas plus spécifiquement développé ici de l'emploi de l'installation 1 pour la microscopie à effet tunnel électronique dans l'ultravide à d'autres applications du type SXM, c'est-à-dire à la microscopie en champ proche optique, à la microscopie à effet tunnel optique, à leur spectroscopie respective, à la gravure de structures nanométriques par des procédés microlithographiques optiques et/ou électroniques, ou encore à toute technique mettant en oeuvre une microsonde placée à proximité immédiate de la surface d'un échantillon. Ces diverses techniques font d'ailleurs l'objet de diverses demandes de brevet en France (à savoir les demandes de brevet FR-89.11297, FR-89.12497, FR-89.14425 et FR-89.14289), dont la mise en oeuvre peut parfaitement être conduite conformément aux enseignements de la présente invention.

## Revendications

1. Installation pour l'étude ou la gravure de la surface d'échantillons (5) placés dans le vide ou dans une atmosphère contrôlée, comportant une enceinte principale (8) dans laquelle est placée une platine support (27) pour au moins un dispositif, dénommé SXM, dans lequel une microsonde, telle qu'une pointe conductrice de l'électricité ou de la lumière, est positionnée à proximité de la surface de l'échantillon (5) à étudier, que ce soit dans l'air ou dans le vide, ce dispositif étant destiné à la microscopie, à la spectroscopie ou à la gravure de la surface d'échantillons (5), par balayage de ladite surface par ladite microsonde, ladite platine support (27) étant pourvue de moyens pour la débrayer de l'enceinte principale (8) et de moyens pour la tourner sur elle-même autour d'un axe central, autorisant l'utilisation d'un ensemble de dispositifs SXM aménagés à la périphérie de ladite platine (27), installation caractérisée en ce que l'enceinte principale (8) est complétée par une enceinte de décapage (6) de la surface des échantillons (5) et par une enceinte d'introduction et de stockage (4) desdits échantillons (5), ceux-ci pouvant être manipulés au travers de l'installation (1) par l'extrémité d'une canne de transfert (15) pouvant être déplacée longitudinalement et en rotation axiale suivant l'axe d'alignement desdites enceintes (4, 6, 8).

2. Installation selon la revendication 1, caractérisée en ce que les échantillons (5) sont montés sur un cadre support (17) dans lequel ils sont maintenus par un contre-cadre (17a), tandis qu'au moins un trou taraudé (17b) est prévu sur le côté dudit cadre (17) de sorte qu'on puisse y visser l'extrémité (15d) de l'arbre (15b) tourillonné dans un manchon coaxial (15c) de la canne de transfert (15), les manoeuvres longitudinales de la canne de transfert (15) étant obtenues par l'intermédiaire d'un dispositif (15a) à crémaillère et pignon coopérant avec ledit arbre (15b).

3. Installation selon l'une quelconque des revendications précédentes, caractérisée en ce qu'un dispositif de stockage (16) des échantillons (5) à analyser ou à graver est placé dans l'enceinte d'introduction et de stockage (4), ce dispositif de stockage (16) se présentant sous la forme d'une étagère (16a) compartimentée pour recevoir les cadres support (17) des échantillons (5), ladite étagère (16a) étant soutenue à sa partie supérieure par une tige verticale (16e) traversant la paroi supérieure de ladite enceinte (4) au niveau d'un joint métallique flexible (18) à soufflets, ladite tige verticale (16e) étant assujettie à un dispositif conventionnel de rotation à translation coaxiale (19) servant à la translation verticale et au pivotement vertical dudit dispositif de stockage (16).

4. Installation selon la revendication 3, caractérisée en ce qu'un élément chauffant (16d) est prévu au dessus de la claie horizontale (16b) la plus haute de l'étagère (16a) et permet, éventuellement, de dégazer un échantillon (5) préalablement placé avec son cadre support (17) sur ladite claie (16b).

5. Installation selon l'une quelconque des revendications précédentes, caractérisée en ce qu'un système support (20) des échantillons (5) est placé dans l'enceinte principale (8), ce système support (20) étant supporté par un bras manipulateur (23) traversant la paroi supérieure de l'enceinte principale (8) au niveau d'un joint métallique flexible (25) soufflets, ledit bras (23) étant assujetti à un dispositif conventionnel de rotation à translation coaxiale (24) servant à la translation verticale et au pivotement vertical dudit système support (20).

6. Installation selon la revendication précédente, caractérisée en ce que le système support (20) est équipé d'un moyen de déplacement vertical (21), susceptible de déplacer verticalement une micro-platine (22) sensiblement horizontale adaptée à recevoir un échantillon (5).

7. Installation selon la revendication précédente, caractérisée en ce que le système support (20) présente deux plans (20a) et (20b) superposés, réunis par trois colonnes verticales (20c) placées chacune entre un sommet du plan supérieur (20a) et un sommet du plan inférieur (20b), ces derniers plans (20a, 20b) étant respectivement munis d'un alésage circulaire supérieur (20d) et d'un alésage circulaire inférieur (20e), l'alésage circulaire supérieur (20d) étant aménagé pour recevoir le moteur à piezoélectrique (21), l'échantillon (5) disposé sur la micro-platine (22) étant amené à proximité de la pointe (26d) d'un dispositif STM (26) reposant sur la platine support (27), par engagement dudit dispositif STM (26) dans ledit alésage circulaire inférieur (20e).

8. Installation selon la revendication précédente, caractérisée en ce que chaque dispositif STM (26) est normalement posé sur une embase (28) fixée sur la platine support (27), un trou (29a) en forme de trièdre, une rainure (29b) en forme de dièdre et un plan (29c) étant usinés dans l'embase (28), formant une emboîture dite "trou/trait/plan" avec trois plots sphériques (20f) situés sous le plan triangulaire inférieur (20b) du système support (20) de l'échantillon (5), juste à l'amplomb de chacune des trois colonnes verticales (20c).

9. Installation selon la revendication précédente, caractérisée en ce que l'embase (28) comporte une partie carrée (28a), au centre de laquelle repose le dispositif STM (26), et un rebord (28b) s'étendant sur le côté le plus interne de ladite partie carrée (28a) pour recevoir des connecteurs électriques horizontaux amenant les fils électriques d'alimentation et de mesure dudit dispositif STM (26) vers des connecteurs verticaux (27a) prévu au centre de la platine support (27).

10. Installation selon la revendication 5, caractérisée en ce que le le moyen de déplacement vertical est un moteur piezoélectrique (21) comportant un cylindre extérieur (21a) à l'intérieur duquel peut être déplacé un cylindre intérieur (21b) soutenant par sa base la micro-platine (22), cette dernière pouvant maintenir le cadre support (17) d'un échantillon (5) par encastrement dans un jeu de lames ressorts (22a).

11. Installation selon l'une quelconque des revendications précédentes, caractérisée en ce que la platine support (27) peut être escamotée par le dessous de l'enceinte principale (8).

12. Installation selon l'une quelconque des revendications précédentes, caractérisée en ce que la platine support (27) repose sur un ensemble de couronnes superposées (30a, 30b et 30c) les unes sur les autres suivant des plans successifs parallèles entre eux, distants les uns des autres de la hauteur de trois amortisseurs (31) identiques réalisés en une matière souple et élastique, disposés angulairement à 120° les uns des autres sur une couronne inférieure (30a, 30b, 30c) pour supporter la couronne qui lui est immédiatement supérieure (27, 30a, 30b respectivement), la couronne (30c) la plus basse constituant une assise pour toutes les autres couronnes (27, 30a, 30b), l'assise constituée par ladite couronne (30c) étant par ailleurs encastrée dans une première couronne extérieure (30d) qui est maintenue en suspension par rapport à une deuxième couronne extérieure (32), elle-même extérieure à la première couronne extérieure (30d), au moyen de trois premiers ressorts (33) identiques, disposés sur la périphérie de ladite première couronne extérieure (30d), à 120° les uns des autres, chacun de ces trois ressorts (33) travaillant en élongation entre un point d'attache inférieur (33a) pris sur la première couronne extérieure (30d) et un point d'attache supérieur (33b) pris au sommet d'une première colonne verticale (34) solidaire de la deuxième couronne extérieure (32), cette dernière étant elle-même maintenue en suspension par rapport à une embase (35) solidaire du bâti de l'enceinte principale (8) au moyen de trois seconds ressorts (36) identiques disposés sur la périphérie de ladite deuxième couronne extérieure (32), chacun de ces trois ressorts (36) travaillant en élongation entre un point d'attache inférieur (36a) pris sur la deuxième couronne extérieure (32) et un point d'attache supérieur (36b) pris au sommet d'une seconde colonne verticale (37) solidaire de ladite embase (35), lesdits premiers ressorts (33) ayant un coefficient de raideur supérieur au coefficient de raideur desdits seconds ressorts (36).

13. Installation selon la revendication précédente, caractérisée en ce que l'empilement de la platine support (27) et des couronnes inférieures (30a, 30b, 30c) présente une forme tronconique.

14. Installation selon l'une quelconque des revendications 12 ou 13, caractérisée en ce que des barreaux aimantés (38) traversent horizontalement de part en part la couronne extérieure (32) pour coopérer, d'une part, avec un premier jeu de masses magnétiques (39) montées solidaires de l'embase (35) pour la stabilisation des oscillations de ladite deuxième couronne extérieure (32) par rapport à ladite embase (35), et, d'autre part, avec un second jeu de masses magnétiques (40) montées solidaires en dessous de la première couronne extérieure (30d) pour la stabilisation des oscillations de ladite première couronne extérieure (30d) par rapport à ladite deuxième couronne extérieure (32).

15. Installation selon l'une quelconque des revendications 12 à 14, caractérisée en ce que l'embase (35) soutenant l'ensemble constitué de la platine support (27), des couronnes inférieures (30a, 30b, 30c), de la première couronne extérieure (30d) et de la seconde couronne extérieure (32) est articulée à sa périphérie autour d'un axe vertical, présentant un fourreau (35a) monté coulissant autour d'un arbre central vertical (35b), ledit fourreau (35a) étant rigidement solidaire de ladite embase (35), de telle sorte que l'on puisse escamoter ledit ensemble par le dessous de l'enceinte principale (8) afin de pouvoir intervenir sur la platine (27) et/ou sur les dispositifs SXM, du type de dispositifs STM (26) destinés la microscopie à effet tunnel électronique, à l'avant de l'installation (1).

16. Installation selon l'une quelconque des revendications 12 à 15, caractérisée en ce que la couronne d'assise (30c) est fixée rigidement à une douille d'accouplement (41) traversant en son centre la première couronne extérieure (30d) dans laquelle est encastrée ladite couronne d'assise (30c), cette douille (41) s'étendant verticalement vers le bas pour coopérer avec un manchon cylindrique creux (42) traversant la paroi inférieure de l'enceinte principale (8) au niveau d'un joint métallique flexible (44) soufflets, ledit manchon (42) étant assujetti à un dispositif conventionnel de rotation à translation coaxiale (43) servant à soulever l'ensemble constitué de la platine support (27), des couronnes inférieures (30a, 30b, 30c) et de la première couronne extérieure (30d), provoquant le relâchement progressif des deux jeux de ressorts (33, 36) jusqu'à ce que ladite couronne d'assise (30c) se désencastre de ladite couronne extérieure (30d) et devienne libre en rotation.

17. Installation selon la revendication précédente, caractérisée en ce que trois tiges horizontales (37a) sont maintenues par les colonnes verticales (37) pour servir de butée haute à la première couronne extérieure (30d), la couronne d'assise (30c) se désencastrant de ladite couronne extérieure (30d) ) à une hauteur prédéterminée par la hauteur desdites tiges horizontales (37a) le long desdites colonnes verticales (37).

18. Installation selon l'une quelconque des revendications 16 ou 17, caractérisée en ce que des connecteurs verticaux (45) sont prévus au centre de la couronne d'assise (30c) pour relier les fils électriques issus des connecteurs verticaux (27a) prévus au centre de la platine support (27), ces connecteurs verticaux (45), propres à chacun des dispositifs SXM d'installations STM (26) destinés la microscopie à effet tunnel électronique, venant normalement au contact de plots conducteurs (45a) soutenus par des petits ressorts (45b), placés à cet effet dans des logements verticaux de la première couronne extérieure (30d) au droit des connecteurs (45), des connecteurs (45c) prolongant par ailleurs les plots conducteurs (45a) vers des fils électriques traversant l'enceinte principale (8) d'une manière conventionnelle.

## Patentansprüche

1. Vorrichtung zur Untersuchung oder Gravierung der Oberfläche von in einem Vakuum oder einer gesteuerten Atmosphäre plazierten Proben (5), mit einer Hauptkammer (8), in der eine Stützplatine (27) für zumindest eine als SXM bezeichnete Einrichtung angebracht ist, in der eine Mikrosonde, wie z. B. eine Elektrizität oder Licht leitende Spitze, in der Nähe der Oberfläche der zu untersuchenden Probe (5) angeordnet ist, und zwar in der Luft oder im Vakuum, wobei diese Einrichtung zur Mikroskopie, zur Spektroskopie oder zur Gravierung der Oberfläche von Proben (5) durch Abtasten der Oberfläche mittels der Mikrosonde bestimmt und die Stützplatine (27) mit Mitteln zu ihrem Ausrücken aus der Hauptkammer (8) und mit Mitteln zu ihrem Drehen um sich selbst um eine mittlere Achse versehen ist, was die Verwendung einer an der Peripherie der Platine (27) eingerichteten Einheit von SXM-Einrichtungen gestattet, **dadurch gekennzeichnet,** daß die Hauptkammer (8) zusätzlich eine Kammer (6) zur Ätzung der Oberfläche der Proben (5) und eine Einfügungs- und Speicherkammer (4) für die Proben (5) aufweist, wobei die Proben durch die Vorrichtung (1) hindurch mit dem Ende eines Überführungsstabes (15), der in Längsrichtung und mit axialer Rotation längs der Ausrichtungsachse der Kammern (4, 6, 8) verschiebbar ist, gehandhabt werden können.

2. Vorrichtung nach Anspruch 1, dadurch gekennzeichnet, daß die Proben (5) auf einem Stützrahmen (17) montiert sind, in dem sie von einem Gegenrahmen (17a) gehalten werden, während zumindest ein mit Innengewinde versehenes Loch (17b) auf der Seite des Rahmens (17) derart vorgesehen ist, daß man dort das Ende (15d) der in einer koaxialen Muffe (15c) des Überführungsstabes (15) drehbar gelagerten Welle (15b) einschrauben kann, wobei die Längsbewegungen des Überführungsstabes (15) mittels einer mit der Welle (15b) zusammenwirkenden Zahnstangeneinrichtung (15a) mit Ritzel hervorrufbar sind.

3. Vorrichtung nach einem der vorhergehenden Ansprüche, dadurch gekennzeichnet, daß eine Speichereinrichtung (16) der zu analysierenden oder gravierenden Proben (5) in der Einfügungs- und Speicherkammer (4) angeordnet ist, wobei die Speichereinrichtung (16) in Form eines unterteilten Regales (16a) zur Aufnahme der Stützrahmen (17) der Proben (5) ausgebildet ist, das am seinem oberen Teil durch einen vertikalen Stab (16e) abgestützt ist, der die obere Wand (4) in Nähe einer biegsamen metallischen Faltenbalgverbindung (18) durchtritt, wobei die vertikale Stange (16e) an eine herkömmliche Rotationseinrichtung mit koaxialer Translation (19) angeschlossen ist, die zur vertikalen Translation und zum vertikalen Verschwenken der Speichereinrichtung (16) dient.

4. Vorrichtung nach Anspruch 3, dadurch gekennzeichnet, daß ein Heizelement (16d) oberhalb des höchsten horizontalen Rostes (16b) des Regales (16a) vorgesehen ist und es eventuell gestattet, eine zuvor mit ihrem Stützrahmen (17) auf dem Rost (16b) angeordnete Probe (5) zu entgasen.

5. Vorrichtung nach einem der vorhergehenden Ansprüche, dadurch gekennzeichnet, daß ein Stützsystem (20) für die Proben (5) in der Hauptkammer (8) angebracht ist, das durch einen Manipulatorarm (23) abgestützt ist, der die obere Wand der Hauptkamme (8) in Höhe einer biegsamen metallischen Faltenbalgverbindung (25) durchtritt und an eine herkömmliche Rotationseinrichtung zur koaxialen Translation (24) angeschlossen ist, die zur vertikalen Translation und zum vertikalen Verschwenken des Stützsystems (20) dient.

6. Vorrichtung nach dem vorhergehenden Anspruch, dadurch gekennzeichnet, daß das Stützsystem (20) mit einer Einrichtung (21) zur vertikalen Verschiebung ausgerüstet ist, mittels derer eine im wesentlichen horizontale, zur Aufnahme einer Probe (5) angepaßte Mikroplatine (22) vertikal verschiebbar ist.

7. Vorrichtung nach dem vorhergehenden Anspruch, dadurch gekennzeichnet, daß das Stützsystem (20) zwei überlagerte Eben (20a und 20b) enthält, die durch drei vertikale Säulen (20c), deren jede zwischen einer Ecke der oberen Ebene (20a) und einer Ecke der unteren Ebene (20b) plaziert ist, miteinander verbunden sind, wobei diese Ebenen (20a, 20b) jeweils mit einer oberen kreisförmigen Bohrung (20d) und einer unteren kreisförmigen Bohrung (20e) versehen sind und die obere kreisförmige Bohrung (20d) zur Aufnahme des piezoelektrischen Motors (21) eingerichtet ist, und wobei ferner die auf der Mikroplatine (22) angeordnete Probe (5) durch Eingriff der STM-Einrichtung (26) in die untere kreisförmige Bohrung (20e) in die Nähe der Spitze (26d) einer auf der Stützplatine (27) ruhenden STM-Einrichtung (26) verbringbar ist.

8. Vorrichtung nach dem vorhergehenden Anspruch, dadurch gekennzeichnet, daß jede STM-Einrichtung (26) senkrecht auf einer auf der Stützplatine (27) befestigten Sitzfläche (28) steht, wobei ein Loch (29a) in Form eines Trieders, eine Rille (29b) in Form eines Dieders und eine Ebene (29c) in die Sitzfläche (28) eingearbeitet sind, wodurch eine sogenannte "Loch/Strich/Ebene" -Verbindung mit drei sphärischen Kontaktstellen (20f) gebildet wird, die sich unterhalb der unteren dreieckförmigen Ebene (20b) des Stützsystem (20) der Probe (5) genau senkrecht zu jeder der drei vertikalen Säulen (20c) befinden.

9. Vorrichtung nach dem vorhergehenden Anspruch, dadurch gekennzeichnet, daß die Sitzfläche (28) einen quadratischen Teil (28a), in dessen Mitte die STM-Einrichtung (26) ruht, und eine Randleiste (28b) aufweist, die sich auf der innersten Seite des quadratischen Teils (28a) erstreckt, um horizontale elektrische Verbindungsstücke aufzunehmen, welche die elektrischen Versorgungs-Meßdrähte der STM-Einrichtung (26) zu vertikalen Verbindungsstücken (27a) führen, die in der Mitte der Stützplatine (27) vorgesehen sind.

10. Vorrichtung nach Anspruch 5, dadurch gekennzeichnet, daß die Einrichtung zum vertikalen Verschieben ein piezoelektrischer Motor (21) mit einem äußeren Zylinder (21a) ist, wobei im Inneren des Zylinders ein innerer Zylinder (21b) verschoben werden kann, der mit seiner Basis die Mikroplatine (22) stützt, die ihrerseits den Stützrahmen (17) einer Probe (5) durch Einspannung in einem Satz Blattfedern (22a) haltern kann.

11. Vorrichtung nach einem der vorhergehenden Ansprüche, dadurch gekennzeichnet, daß die Stützplatine (27) durch das Unterteil der Hauptkammer (8) absenkbar ist.

12. Vorrichtung nach einem der vorhergehenden Ansprüche, dadurch gekennzeichnet, daß die Stützplatine (27) auf einem Satz Kronen (30a, 30b und 30c) ruht, die einander gemäß aufeinanderfolgender, untereinander paralleler Ebenen überlagert und zwar zueinander um die Höhe dreier identischer Dämpfer (31) beabstandet sind, wobei diese Dämpfer aus einem nachgiebigen und elastischen Material bestehen und unter einem Winkel von 120° zueinander auf einer unteren Krone (30a, 30b, 30c) angeordnet sind, um die unmittelbar darüberliegende Krone (27 bzw. 30a bzw. 30b) zu haltern, wobei die unterste Krone (30c) eine Auflagefläche für alle anderen Kronen (27, 30a, 30b) bildet, die durch diese Krone (30c) gebildete Auflagefläche außerdem in einer ersten äußeren Krone (30d) eingespannt ist, die bezüglich einer zweiten äußeren Krone (32), welche ihrerseits außerhalb der ersten äußeren Krone (30d) liegt, aufgehängt ist, und zwar mit Hilfe von drei identischen, auf dem Randbereich der ersten äußeren Krone (30d) um 120° zueinander versetzt angeordneten ersten Federn (33), deren jede auf Dehnung zwischen einem auf der ersten äußeren Krone (30d) vorgesehenen unteren Befestigungspunkt (33a) und einem oberen Befestigungspunkt (33b) arbeitet, der am Scheitel einer ersten vertikalen Säule (34) vorgesehen ist, die fest mit der äußeren zweiten Krone (32) verbunden ist, wobei letztere ihrerseits bezüglich einer mit dem Tragelement der Hauptkammer (8) fest verbundenen Sitzfläche (35) aufgehängt ist mittels drei identischer zweiter Federn (36) am Randbereich der äußeren zweiten Krone (32), wobei jede dieser drei Federn (36) auf Dehnung zwischen einem auf der äußeren zweiten Krone (32) vorgesehenen unteren Befestigungspunkt (36a) und einem oberen Befestigungspunkt (36b) arbeitet, der am Scheitel einer an der Sitzfläche (35) befestigten, zweiten vertikalen Säule (33) vorgesehen ist, wobei die ersten Federn (31) einen Steifigkeitskoeffizienten aufweisen, der größer als der Steifigkeitskoeffizient der zweiten Federn (36) ist.

13. Vorrichtung nach dem vorhergehenden Anspruch, dadurch gekennzeichnet, daß die Stapelung der Stützplatine (27) und der unteren Kronen (30a, 30b, 30c) eine konische Form bildet.

14. Vorrichtung nach einem der Ansprüche 12 oder 13, dadurch gekennzeichnet, daß magnetisierte Stäbe (38) vollständig durch die äußere Krone (32) hindurchlaufen, um einerseits mit einem ersten Satz magnetischer Massen (39), die zur Stabilisierung der Schwingungen der äußeren zweiten Krone (32) bezüglich der Sitzfläche (35) fest auf letzterer montiert sind, und andererseits mit einem zweiten Satz magnetischer Massen (40) zusammenwirken, die fest unterhalb der ersten äußeren Krone (39d) montiert sind, um die Schwingungen der äußeren ersten Krone (30d) bezüglich der äußeren zweiten Krone (32) zu stabilisieren.

15. Vorrichtung nach einem der Ansprüche 12 bis 14, dadurch gekennzeichnet, daß die Sitzfläche (35), welche die durch die Stützplatine (27) die unteren Kronen (30a, 30b, 30c), die äußere erste Krone (30d) und die äußere zweite Krone (32) gebildete Einheit stützt, an ihrem Randbereich um eine vertikale Achse verschwenkbar befestigt ist, die als Buchse (35a) ausgebildet ist, welche gleitend auf einer vertikalen mittleren Welle (35b) sitzt, wobei die Buchse (35a) mit der Sitzfläche (35) fest derart verbunden ist, daß man die Einheit durch das Unterteil der Hauptkammern (8) absenken kann, um auf die Platine (27) und/oder auf die SMX-Einrichtungen, die vom Typ der STM-Einrichtungen (26) zur elektronischen Tunneleffektmikroskopie sind, vorne an der Vorrichtung (1) Zugriff zu haben.

16. Vorrichtung nach einem der Ansprüche 12 bis 15, dadurch gekennzeichnet, daß die Krone (30c) mit der Auflagefläche starr an einer Kupplungshülse (41) befestigt ist, welche mittig die äußere erste Krone (30d) durchquert, in der die Krone (30c) mit der Auflagefläche eingespannt ist, wobei sich die Hülse (41) zum Zusammenwirken mit einer hohlen zylindrischen Muffe (42) vertikal nach unten erstreckt und die Muffe die untere Wand der Hauptkammer (8) auf der Höhe einer biegsamen metallischen Faltenbalgverbindung (44) durchquert, und wobei die Muffe (42) an eine herkömmliche Rotationseinrichtung (43) zur koaxialen Translation angeschlossen ist, die dazu dient, die durch die Stützplatine (27), die unteren Kronen (30a, 30b, 30c) und die äußere erste Krone (30d) gebildet Einheit zu heben, wodurch eine zunehmende Entspannung der beiden Sätze Federn (33, 36) ausgelöst wird, bis sich die Krone (30c) mit der Anlagefläche aus der Einspannung an der äußeren Krone (30d) löst und frei verdrehbar wird.

17. Vorrichtung nach dem vorhergehenden Anspruch, dadurch gekennzeichnet, daß drei horizontale Stangen (37a) durch die vertikalen Säulen (37) gehaltert werden um als ein oberer Anschlag an der äußeren ersten Krone (30d) zu dienen, wobei sich die Krone (30c) mit der Anlagefläche aus der Einspannung an der äußeren Krone (30d) bei einer Höhe löst, die durch die Höhe der horizontalen Stäbe (37a) entlang der vertikalen Säulen (37) vorgegeben ist.

18. Vorrichtung nach einem der Ansprüche 16 oder 17, dadurch gekennzeichnet, daß vertikale Verbindungsstücke (45) in der Mitte der Krone (30c) mit der Anlagefläche vorgesehen sind, um die aus den im Mittelpunkt der Stützplatine (27) vorgesehenen vertikalen Verbindungsstücken (27a) hervorkommenden elektrischen Drähte zu verbinden, wobei die vertikalen Verbindungsstücke (45), die jeder der SXM-Einrichtungen von STM-Einrichtungen (26) zur elektrischen Tunneleffektmikroskopie angehören, senkrecht in Kontakt mit Kontaktleitern (45a) stehen, die durch kleine Federn (45b) gehalten werden, welche hierfür in vertikalen Sitzen der ersten äußeren Krone (30d) neben den Verbindungsstücken (45) angebracht sind, wobei diese Verbindungsstücke (45c) außerdem die Kontaktleiter (45a) zu elektrischen Drähten hin verlängern, welche die Hauptkammer (8) auf herkömmliche Weise durchqueren.

## Claims

1. An installation for the study or engraving of the surface of specimens (5) placed in a vacuum or in a controlled atmosphere, having a main enclosure (8) in which is disposed a support plate (27) for at least one device, designated SXM, in which a microprobe, such as an electrically or light conductive tip, is positioned close to the surface of the specimen (5) to be studied, whether it be in air or in a vacuum, this device being intended for microscopy, spectroscopy or engraving of the surface of the specimens (5), by sweeping of the surface by the microprobe, the support plate (27) being provided with means for its disengagement from the main enclosure (8) and with means for rotating it on itself about a central axis, permitting the use of an assembly of SXM devices disposed on the periphery of the plate (27), the installation being characterised in that the main enclosure (8) is completed by an enclosure (6) for cleaning the surface of the specimens (5) and by an insertion and storage enclosure (4) for the specimens (5), which latter can be manipulated through the installation (1) by the end of a transfer rod (15) which can be moved longitudinally and in axial rotation along the axis of alignment of the enclosures (4, 5, 8).

2. An installation according to Claim 1, characterised in that the specimens (5) are mounted on a support frame (17) in which they are held by a counter-frame (17a), whilst at least one threaded hole (17b) is provided on the side of the frame (17) such that the end (15d) of the shaft (15b) pivoted in a coaxial sleeve (15c) of the transfer rod (15) can be screwed thereon, longitudinal manoevering of the transfer rod (15) being produced by means of a rack and pinion device (15a) cooperating with the shaft (15b).

3. An installation according to either of the preceding claims, characterised in that a storage device (16) for the specimens (5) to be analysed or engraved is disposed in the insertion and storage enclosure (4), this storage device (16) being in the form of a rack (16a) compartmented to receive the support frames (17) of the specimens (5), said rack (16a) being supported at its upper portion by a vertical rod (16e) passing through the upper wall of the enclosure (4) in the region of a flexible metal bellows joint (18), the vertical rod (16e) being subject to a conventional device (19) for rotation in coaxial translation, serving for the vertical translation and vertical pivoting of said storage device (16).

4. An installation according to Claim 3, characterised in that a heating element (16d) is provided above the uppermost horizontal tray (16b) of the rack (16a) and allows, on occasion, the degassing of a specimen (5) previously placed with its support frame (17) on the tray (16b).

5. An installation according to any one of the preceding claims, characterised in that a support system (20) for the specimens (5) is disposed in the main enclosure (8), this support system (20) being supported by a manipulator arm (23) passing through the upper wall of the main enclosure (8), in the region of a flexible metal bellows joint (25), the arm (23) being subject to a conventional device for rotation in coaxial translation (24) serving for the vertical translation and vertical pivoting of the support system (20).

6. An installation according to the preceding claim, characterised in that the support system (20) is equipped with a vertical displacement means (21), able to move vertically a substantially horizontal micro-plate (22) adapted to receive a specimen (5).

7. An installation according to the preceding claim, characterised in that the support system (20) has two superposed planar elements (20a) and (20b), joined by three vertical columns (20c) each disposed between the bottom of the upper element (20a) and the top of the lower element (20b), these latter planar elements (20a, 20b) being respectively provided with an upper circular bore (20d) and a lower circular bore (20e), the upper circular bore (20d) being formed to receive the piezoelectric motor (21), the specimen (5) disposed on the micro-plate (22) being brought close to the tip (26d) of an STM device (26) resting on the support plate (27), by engagement of the STM device (26) in the lower circular bore (20e).

8. An installation according to the preceding claim, characterised in that each STM device (26) is normally disposed on a base (28) fixed on the support plate (27), a trihedral hole (29a), a dihedral groove (29b) and a flat (29c) being machined in the base (28), forming a so-called "hole/line/flat" interlock with three spherical studs (20f) located in the lower triangular planar element (20b) of the support system (20) of the specimen (5), exactly vertically in line with each of the three vertical columns (20c).

9. An installation according to the preceding claim, characterised in that the base (28) has a square portion (28a) at the centre of which rests the STM device (26), and a raised edge (28b) extending over the innermost side of the square portion (28a) to receive horizontal electrical connectors bringing the electrical supply and measurement wires of the STM device (26) to the vertical connectors (27a) provided in the centre of the support plate (27).

10. An installation according to Claim 5, characterised in that the vertical displacement means is a piezoelectric motor (21) having an external cylinder (21a) within which may be moved an internal cylinder (21b) supporting the micro-plate (22) by its base, this latter being able to hold the support frame (17) of a specimen (5) by letting into in a set of blade springs (22a).

11. An installation according to any one of the preceding claims, characterised in that the support plate (27) may be retracted beneath the main enclosure (8).

12. An installation according to any one of the preceding claims, characterised in that the support plate (27) rests on an assembly of rings (30a, 30b and 30c) superposed one on the other in successive parallel planes, distant from one another by the height of three identical damping devices (31) made of a resilient and flexible material, disposed angularly at 120° to one another on a lower ring (30a, 30b, 30c) to support the ring which is immediately above it (27, 30a, 30b respectively), the lowest ring (30c) constituting a bed for all the other rings (27, 30a, 30b), the bed constituted by the ring (30c) being, moreover, let into a first external ring (30d) which is held in suspension with respect to a second external ring (32), itself external to the first external ring (30d), by means of three identical first springs (33), disposed on the periphery of said first external ring (30d), at 120° from one another, each of these three springs (33) acting in extension between a lower attachment point (33a) on the first external ring (30d) and an upper attachment point (33b) at the top of a first vertical column (34) connected to the second external ring (32), this latter itself being held in suspension with respect to a base (35) connected to the frame of the main enclosure (8) by means of three identical second springs (36) disposed on the periphery of the second external ring (32), each of these three springs (36) working in extension between a lower attachment point (36a) on the second external ring (32) and an upper attachment point (36b) at the top of a second vertical column (37) connected to the base (35), the first springs (33) having a coefficient of stiffness greater than the coefficient of stiffness of the second springs (36).

13. An installation according to the preceding claim, characterised in that the stacking of the support plate (27) and the lower rings (30a, 30b, 30c) has a truncated cone shape.

14. An installation according to either of Claims 12 or 13, characterised in that magnetised bars (38) extend horizontally right through the external ring (32) to cooperate, on the one hand, with a first set of magnetic masses (39) mounted rigidly with the base (35) to stabilise the oscillations of the second external ring (32) with respect to the base (35), and, on the other hand, with a second set of magnetic masses (40) mounted rigidly below the first external ring (30d) to stabilise the oscillations of the first external ring (30d) with respect to the second external ring (32).

15. An installation according to any one of Claims 12 to 14, characterised in that the base (35) supporting the assembly constituted by the support plate (27), the lower rings (30a, 30b, 30c), the first external ring (30d) and the second external ring (32) is pivoted at its periphery about a vertical axis, having a sleeve (35a) slidably mounted about a central vertical shaft (35b), the sleeve (35a) being rigidly connected to the base (35), such that the assembly can be retracted below the main enclosure (8) in order to be able to intervene on the plate (27) and/or on the SXM devices, of the STM device type (26) intended for electronic tunnel effect microscopy at the front of the installation (1).

16. An installation according to any one of Claims 12 to 15, characterised in that the seating ring (30c) is fixed rigidly to a coupling bush (41) passing through at its centre the first external ring (30d) in which is let into the seating ring (30c), this bush (41) extending vertically downwardly to cooperate with a hollow cylindrical sleeve (42) passing through the lower wall of the main enclosure (8) in the region of a flexible metal bellows joint (44), the sleeve (42) being subject to a conventional device for rotation in coaxial translation (43) serving to raise the assembly constituted by the support plate (27), the lower rings (30a, 30b, 30c) and the first external ring (30d), causing the progressive release of the two sets of springs (33, 36) until the seating ring (30c) is removed from the external ring (30d) and becomes free for rotation.

17. An installation according to the preceding claim, characterised in that three horizontal rods (37a) are held by the vertical columns (37) to act as an upper abutment for the first external ring (30d), the seating ring (30c) becoming removed from the external ring (30d) at a height predetermined by the height of the horizontal rods (37a) along the vertical columns (37).

18. An installation according to either of Claims 16 or 17, characterised in that vertical connectors (45) are provided at the centre of the seating ring (30c) to connect the electric wires coming from vertical connectors (27a) provided at the centre of the support plate (27), these vertical connectors (45), belonging to each of the SXM devices of the STM installations (26) intended for electronic tunnel effect microscopy, normally coming into contact with conductive studs (45a) supported by small springs (45b), for this purpose, in vertical housings of the first external ring (30d) at right angles to the connectors (45), connectors (45c) extending, moreover, the conductive studs (45a) towards electric wires passing through the main enclosure (8) in a conventional manner.
